# EUROPÄISCHE PATENTANMELDUNG

(11) **EP 2 302 699 A2**
(43) Veröffentlichungstag der Anmeldung: **30.03.2011**
(21) Anmeldenummer: 10008988.7
(22) Anmeldetag: 30.08.2010
(51) Int. Cl.: H01L 31/052

(54) **Solarzelle mit pigmentierten dielektrischen Reflektor**

(30) Priorität: 28.09.2009 DE 102009043047
(71) Anmelder: Schott Solar AG, 55122 Mainz (DE)
(72) Erfinder: Hagemann, Volker, Dr., 55270 Klein-Winternheim (DE); Bockmeyer, Matthias, Dr., 55116 Mainz (DE); Lechner, Peter, 85591 Vaterstetten (DE); Berginski, Michael, Dr., 45277 Essen (DE)

(57) **Zusammenfassung**

Die Erfindung betrifft eine Solarzelle mit einem pigmentierten dielektrischen Reflektor (5), wobei der dielektrische Reflektor vorzugsweise zwei dielektrische Schichten (6,7) mit unterschiedlichen Brechungsindizes sowie in die Schichten eingebettete Pigmente (10) umfasst, wodurch bei geringer Schichtdicke des Reflektors eine hoher Wirkungsgrad der Solarzelle erreicht wird. Die Erfindung betrifft ferner geeignete Materialsysteme zur Realisierung des dielektrischen Reflektors.

## Beschreibung

Die vorliegende Erfindung betrifft eine Solarzelle mit einem dielektrischen pigmentierten Reflektor.

Solarzellen verschiedener Bauformen weisen in der Regel einen Rückreflektor auf, welcher den optischen Weg der Strahlung durch den photovoltaischen Absorber vergrößert, wodurch die Absorption und damit der Wirkungsgrad der Solarzelle verbessert wird.
Zum einen sind aus dem Stand der Technik metallische Reflektoren zum Beispiel aus Al oder Ag bekannt, welche eine metallische, gerichtete Reflektion der einfallenden Strahlung bewirken. Bei senkrechter Ausrichtung der Solarzelle zu der Hauptstrahlungsquelle und ebener Reflektorschicht kann damit der optische Weg durch den photovoltaischen Absorber etwa verdoppelt werden. Zusätzlich kann der optische Reflektor eine mikrostrukturierte, rauhe Oberfläche aufweisen, wodurch die Strahlung teilweise schräg zur Lichteinfallsachse reflektiert wird und damit einen längeren Weg durch den Absorber hat.

Aus dem Stand der Technik ist ebenso die Verwendung von pigmentierten dielektrischen Reflektoren bekannt, welche entgegen den metallischen Reflektoren eine diffuse, nicht gerichtete Reflexion aufweisen und welche die einfallende Strahlung in einen weiten Winkelbereich streuen. Im Idealfall wird die einfallende Strahlung von einem planen Reflektor aus einem dielektrischen Material mit Lambertscher Streucharakteristik, d.h mit konstanter Strahldichte in den Halbraum zurückgestreut. Die Winkelverteilung der zurückgestreuten Strahlung, die auch als Streukeule bezeichnet wird, besitzt in diesem Fall eine Breite von 180°, wobei die Strahlstärke dem Lambert'schen Kosinusgesetz folgt. Die diffus reflektierte Strahlung kann durch den Absorber im Allgemeinen effizienter als bei einem metallischen Reflektor auf einer glatten Halbleiteroberfläche absorbiert werden, da sich der optische Weg der Strahlung durch den Absorber bei einer Reflexion schräg zur Einfallsrichtung mehr als verdoppelt. Zudem kann es für schräg reflektiertes Licht zu Totalreflektion z.B. an der Grenzfläche der Absorberschicht zur Elektrodenschicht kommen, so dass die verbleibende Strahlung erneut den Absorber durchläuft. Der resultierende Lichtweg der Strahlung durch den Absorber kann damit noch weit größer als die doppelte Absorberschichtdicke sein. Dieser Effekt wird auch als Light-Trapping bezeichnet. Grundsätzlich kann ein dielektrischer Reflektor auch auf rauen Oberflächen eingesetzt werden, wobei sich dann Effekte der Grenzflächenstreuung und der Volumenstreuung aus dem dielektrischen Reflektor überlagern.

Im Falle eines dielektrischen Reflektors ist zwischen der photovoltaisch aktiven Schicht und dem elektrisch nicht leitfähigen Reflektor in der Regel eine transparente leitfähige Oxidschicht oder kurz TCO (Transparent Conductive Oxide)-Schicht vorhanden, über weiche der Photostrom abgeführt wird, da der Rückreflektor mangels elektrischer Leitfähigkeit im Gegensatz zu dem metallischen Reflektor nicht als Rückelektrode geeignet ist. Entsprechend befindet sich der dielektrische Reflektor dann auf dieser TCO-Schicht, so dass die reflektierte Strahlung die TCO-Schicht erneut durchlaufen muss, bevor sie wieder in den photovoltaischen Absorber eintritt. Durch starke Dotierung der Halbleiterschichten kann aber auch die Leitfähigkeit der photovoltaischen Schicht so stark erhöht werden, dass diese selbst den Photostrom abführen kann. In diesem Fall befindet sich der dielektrische Rückreflektor direkt auf der Halbleiterschicht.

In W02005/076370 A2 wird zum Beispiel die Verwendung eines dielektrischen Reflektors in Form einer weißen Farbe vorgeschlagen, die aus einem Trägerstoff mit Pigmenten besteht, wobei das Verhältnis der Brechzahl n der Pigmente zu der Brechzahl des Trägerstoffes im Bereich 1,4 bis 2 liegt, und derAnteil der Pigmente in der weißen Farbe 10 bis 100 Vol.-% beträgt. Als Pigmente werden Partikel z.B. aus BaSO₄ oder TiO₂ mit einer Korngröße von 0,2 µm bis 2 µm genannt. Als Trägerstoffe für die Pigmente werden organische Trägermaterialien wie EVA (ethyl-vinyl-acetate) sowie die Trägerstoffe handelsüblicher Farben genannt. Der dielektrische Reflektor kann entweder in Form einer weißen Farbe oder aber auch in Form einer Folie, welche die Pigmente enthält, aufgetragen werden. Nachteilig an den beschriebenen Trägerstoffen ist jedoch eine geringer Brechzahl des Trägerstoffes, was sowohl für EVA-Folie als auch für die genannten handelsüblichen weißen Farben gilt, da sich aus dem starken Unterschied der Brechzahl von dielektrischem Reflektor und Halbleiterschicht gemäß dem Snellschen Brechungsgesetz eine starke Brechung der Strahlung ergibt. Die Breite der Winkelverteilung des zurückgestreuten Lichtes wird dadurch beim Übergang zum Si mit einer hohen Brechzahl von n ≈ 3,7 auf einen deutlich geringeren Öffnungswinkel reduziert und damit kann die Solarzelle nicht das optimale Light-Trapping-Potenzial entfalten.

In dem Artikel "Novel light-trapping schemes involving planar junctions and diffuse rear reflectors for thin-film silicon-based solar cells", K. Winz et al., Solar Energy Materials and Solar Cells 49 (1997),195-203, wird für den Fall des direkten Farbauftrags auf Silizium die Verwendung einer Farbe mit hoher Brechzahl des Trägerstoffes vorgeschlagen. Dadurch wird die Brechung an der Grenzfläche zum Si-Absorber verringert, so dass sich der Öffnungswinkel der Streukeule im Si-Absorber vergrößert und das Light-Trapping verbessert wird. Nachteilig an dieser Lösung ist, dass bei Anheben der Brechzahl des Trägerstoffes unter Verwendung der gleichen Pigmente das Deckungsvermögen der Farbe abnimmt und die Farbschicht entsprechend dicker sein muss, um eine ausreichende Deckung zu erreichen.

Die Aufgabe der Erfindung ist daher die Bereitstellung einer Solarzelle mit einem dielektrischen Reflektor mit einem hohen Reflektionsgrad, welcher gegenüber dem Stand der Technik gleichzeitig eine geringe Schichtdicke sowie eine möglichst breite Streukeule der in den Absorber zurückgestreuten Strahlung und damit gute Light-Trapping Eigenschaften und einen hohen Wirkungsgrad aufweist.

Die Aufgabe wird gelöst durch den Hauptanspruch. Bevorzugte Ausführungsformen sind in den Unteransprüchen ausgeführt.

Der Hauptanspruch betrifft eine Solarzelle [1] mit einer Frontelektrodenschicht [2], einer photovoltaisch aktiven Absorberschicht [3], einer Rückelektrodenschicht [4] sowie einem pigmentierten dielektrischen Reflektor [5].

Bei der Solarzelle [1] kann es sich sowohl um kristalline Solarzellen auf Basis eines Halbleiter-Wafers als auch um Dünnschichtsolarzellen mit einer Substrat- oder Superstratkonfiguration handeln, wobei die einfallende Strahlung im Falle einer Superstratanordnung durch das Substrat auf die Absorberschicht gelangt. Die Solarzelle [1] kann ferner weitere Elemente zum Beispiel zur Kontaktierung sowie zur Rückseitenverkapselung umfassen, welche nicht wesentlich für den Erfindungsgegenstand sind.

Die Frontelektrodenschicht [2] kann z.B. eine TCO-Schicht aus SnO₂, ITO (indium tin oxide) oder ZnO umfassen, wobei ZnO vorzugsweise mit Al, Ga oder B dotiert ist und SnO₂ und/oder ITO vorzugsweise mit F dotiert sind. Die Frontelektrodenschicht [2] kann aber auch in Form einer Halbleiterschicht in Verbindung mit einer nicht geschlossenen Metallschicht z.B. durch auf den Halbleiter aufgedruckte Leiterbahnen vorliegen. Die elektrische Leitfähigkeit der halbleitenden Schicht kann dabei durch starke Dotierung erhöht sein.

Die photovoltaisch aktive Absorberschicht [3], in welcher die Umwandlung der optischen Energie in elektrische Energie erfolgt, kann auf dem Halbleitermaterial Si in amorpher oder kristalliner Form basieren, es kann sich jedoch auch um andere Materialsysteme wie CdTe oder CIGS ( Cu(In, Ga) (S, Se)₂) handeln. Die photovoltaisch aktive Absorberschicht [3] kann einen oder mehrere p-n-Übergange umfassen, es kann sich zum Beispiel um Einzel- oder Mehrfachstapelzellen (insb. Tandem- oder Triple-Junction-Stapelzellen) aus amorphem und/oder mikrokristallinem Halbleitermaterial handeln,

Die Rückelektrodenschicht [4] kann ebenfalls eine TCO-Schicht aus SnO₂, ITO oder ZnO umfassen, wobei ZnO vorzugsweise mit Al, Ga oder B dotiert ist und SnO₂ und/oder ITO vorzugsweise mit F dotiert sind. Die Rückelektrodenschicht kann aber auch Teil der Absorberschicht [3] sein. Durch oberflächennahe Dotierung der im allgemeinen halbleitenden Absorberschicht kann deren Leitfähigkeit dort so weit gesteigert werden, dass der Strom über die Absorberschicht abgeführt werden kann.

Der pigmentierte dielektrische Reflektor [5] zeichnet sich allgemein dadurch aus, dass er aus einem elektrisch nicht leitfähigen Trägerstoff besteht, in welchem Pigmente eingebettet sind, welche eine Lichtstreuung bewirken. Er zeichnet sich durch diffuse Reflektion aus und ist aufgrund seiner spektralen Reflektionseigenschaften im allgemeinen weiß.

Mit Brechzahl ist in der vorliegenden Offenbarung immer der Wert des Brechungsindexes bei einer Wellenlänge von etwa 800 nm bezeichnet. Die kurzwelligere solare Strahlung wird im allgemeinen in der Regel schon beim ersten Durchgang der Strahlung durch die photovoltaischen Absorberschicht absorbiert, so dass diese den dielektrischen Reflektor nicht erreicht. Der entsprechende kurzwellige Wellenlängenbereich umfasst je nach Absorbermaterial und Schichtdicke den Bereich 300 nm bis 500 nm oder 300 nm bis 600 nm. Der dielektrische Reflektor reflektiert daher in erster Linie Strahlung des Wellenlängenbereiches oberhalb von 500 nm bis 600 nm, wobei die Wellenlänge von 800 nm stellvertretend für diesen Bereich betrachtet wird. Die Änderung der Brechzahl mit der Wellenlänge kann in der vorliegenden Offenbarung vernachlässigt werden, da sie klein gegenüber den Brechzahlunterschieden der Einzelschichten innerhalb des Schichtsystems ist.

Die erfindungsgemäße Solarzelle ist **dadurch gekennzeichnet, dass** der pigmentierte dielektrische Reflektor [5] senkrecht zu den Funktionsschichten [3, 4, 5] einen Brechzahlverlauf mit zumindest zwei unterschiedlichen Brechzahlen n₁ und n₂ aufweist, mit einer Brechzahl n₁ in einem Abstand d₁ vom Absorber und einer Brechzahl n₂ in einem Abstand d₂ vom Absorber, wobei die Brechzahl n₁ näher dem Absorber größer ist als die Brechzahl n₂ ferner dem Absorber. Die Brechzahl des pigmentierten dielektrischen Reflektors wird bei dem angewendeten physikalischen Modell dabei mit der Brechzahl des Trägerstoffes ohne Berücksichtigung der Pigmente gleichgesetzt.

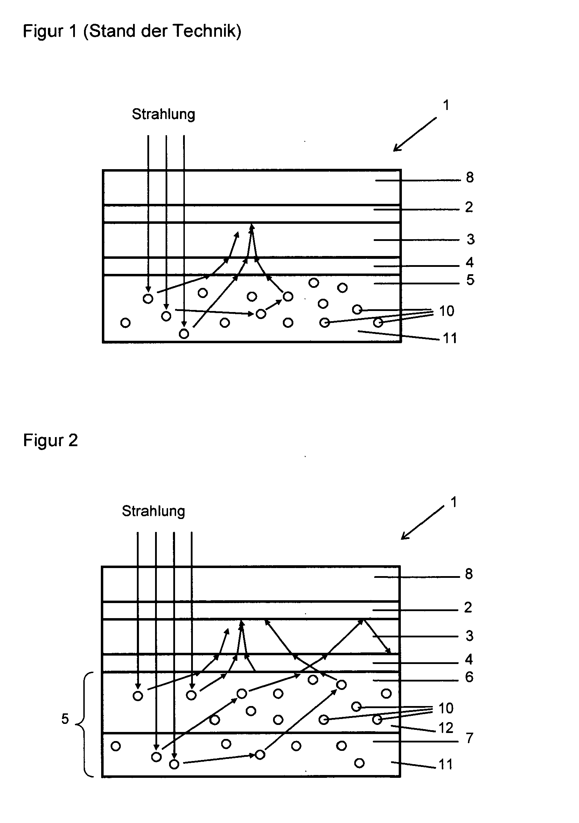

Die Erfindung wird im folgenden exemplarisch für den Fall dargestellt, dass der Brechzahlverlauf des pigmentierten dielektrischen Reflektors [5] zwei unterschiedliche Brechzahlen aufweist. In diesem Fall, welcher in Figur 2 dargestellt ist, weist der dielektrische Reflektor [5] einen zweischichtigen Aufbau mit einer hochbrechenden ersten [6] und einer niedrigbrechenden zweiten Reflektorschicht [7] auf. Die hohe Brechzahl auf der der Absorberschicht [3] zugewandten Seite des Reflektors [6] bewirkt vorteilhaft, dass die Breite der Winkelverteilung der in die Absorberschicht zurückgestreuten Strahlung beim Übergang in die Absorberschicht nicht so stark verringert wird, wie es bei einer niedrigbrechenden Reflektorschicht der Fall ist. So wird z.B. eine Streukeule mit einer maximal möglichen Breite der Winkelverteilung von 180° in einer niedrigbrechenden Schicht mit einer Brechzahl von n = 1,5 in einer hochbrechenden Absorberschicht mit einer Brechzahl von n = 4 auf eine Breite der Winkelverteilung von nur ca. 44° reduziert. Dieser Fall ist in Figur 1 dargestellt. Bei dem Übergang von einer hochbrechenden Schicht mit einer Brechzahl von n = 1,8 in eine hochbrechende Absorberschicht mit einer Brechzahl von n = 4 wird die Breite der Winkelverteilung in der hochbrechenden Absorberschicht auf einen Wert von noch 53 ° reduziert. Durch die größeren Streuwinkel verlängert sich der optische Weg der reflektierten Strahlung in der Absorberschicht und die Light-Trapping-Eigenschaften der Solarzelle werden verbessert.

Wird in der hochbrechenden und der niedrigbrechenden Reflektorschicht das gleiche Pigment verwendet, so besitzt der Trägerstoff der hochbrechenden Reflektorschicht im allgemeinen ein geringeres Deckungsvermögen, da das Deckungsvermögen von dem Brechzahlunterschied zwischen Pigmenten und Trägerstoff abhängt. In erster Näherung kann davon ausgegangen werden, dass das Deckungsvermögen einer Reflektorschicht mit einem Trägerstoff mit einer Brechzahl n_{T} und Pigmenten mit einer Brechzahl n_{P} proportional zu dem Ausdruck (n_{P}-n_{T})²/(n_{P}+n_{T})² ist. Für eine Pigmentbrechzahl von 2,5 ergibt sich daraus ein um den Faktor 2,3 geringeres Deckungsvermögen, wenn die Brechzahl des Trägerstoffes von 1,5 auf 1,8 angehoben wird. Entsprechend müsste in diesem Beispiel der hochbrechende Reflektor eine um den Faktor 2,3 höhere Schichtdicke als der niedrigbrechende Reflektor aufweisen, damit dieselbe Opazität erreicht wird. Ein hochbrechender Reflektor muss daher eine deutliche größere Schichtdicke aufweisen, wenn er eine ausreichend hohe Opazität beziehungsweise eine ausreichend geringe Transluzenz von annähernd 0 % aufweisen soll.

Erfindungsgemäß wird jedoch der hochbrechende Reflektor durch eine zweite niedrigbrechende Reflektorschicht ergänzt, welche aufgrund einer geringeren Brechzahl des Trägerstoffes ein höheres Deckungsvermögen aufweist und damit schon bei geringen Schichtdicken eine ausreichende Opazität erreicht wird. Die Strahlung, die von dieser niedrigbrechenden Schicht in die Richtung der Absorberschicht zurückgestreut wird, durchläuft dann wiederum die hochbrechende Reflektorschicht und kann durch weitere Streuung dennoch in die erweiterte Streukeule gestreut werden. Am Übergang zwischen niedrigbrechender und hochbrechender Reflektorschicht findet dabei auch eine Brechung statt, die zu einer Reduzierung der Breite der Winkelverteilung führt. Die von der niedrigbrechenden Schicht reflektierte Strahlung kann jedoch durch weitere Streuvorgänge innerhalb der hochbrechenden Schicht wieder in den Bereich der erweiterten Streukeule gestreut werden, so dass insgesamt eine effektive Verbreiterung der Streukeule erreicht wird, beziehungsweise eine Anhebung der Breite der Winkelverteilung.

Das an einem zweischichtigen Reflektor erläuterte Funktionsprinzip kann alternativ auch durch einen mehrschichtigen dielektrischen Reflektor mit drei oder mehr Reflektorschichten mit abgestuftem Brechzahlverlauf oder auch durch eine Reflektorschicht mit einer kontinuierlich zur Absorberschicht hin ansteigenden Brechzahl realisiert werden. Der Brechzahlverlauf kann abschnittweise auch mit zunehmendem Abstand vom Absorber zunehmen, was das Auftreten der erfindungsgemäßen Vorteile verringert, jedoch bei entsprechend Auslegung des Brechzahlverlaufes (geringe Schichtdicke, geringer Brechzahlunterschied) weiterhin das Erreichen der erfindungsgemäßen Vorteile ermöglicht. Im allgemeinen kann der Aufbau der erfindungsgemäßen Solarzelle daher dadurch beschrieben werden, dass der pigmentierte dielektrische Reflektor [5] senkrecht zu den Funktionsschichten [3, 4, 5] einen Brechzahlverlauf mit zumindest zwei unterschiedlichen Brechzahlen n₁ und n₂ aufweist, mit einer Brechzahl n₁ in einem Abstand d₁ vom Absorber und einer Brechzahl n₂ in einem Abstand d₂ vom Absorber, wobei die Brechzahl n₁ näher dem Absorber größer ist als die Brechzahl n₂ ferner dem Absorber.

Im folgenden werden bevorzugte Ausführungsformen der Erfindung dargestellt. In einer ersten bevorzugten Ausführungsform wird die Rückelektrodenschicht durch eine TCO-Schicht mit einer Brechzahl n_{R} gebildet, wobei die maximale Brechzahl des dielektrischen Reflektors höchstens der Brechzahl n_{R} der TCO-Schicht entspricht. In diesem Fall ergibt sich die Schichtfolge Reflektor-TCO-Absorber, welche dem Standardaufbau z.B. von Dünnschichtsolarzellen mit einem dielektrischen Reflektor entspricht. Eine TCO-Schicht weist in der Regel eine Brechzahl auf, welcher zwischen dem des dielektrischen Reflektors (im Stand der Technik: n ≈ 1,5) und dem des Absorbers (für Si: n ≈ 3,7) liegt. Das häufig verwendete TCO-Material ZnO weist zum Beispiel eine Brechzahl von ungefähr 1,8 auf. Im Fall einer zusätzlichen TCO-Schicht kommt es an den beiden Grenzflächen Reflektor-TCO und TCO-Absorber zu einer Gesamtbrechung, die in ihrer Wirkung einer Brechung zwischen Reflektor-Absorber entspricht. Im Fall einer zusätzlichen TCO-Schicht zwischen Rückelektrode und Absorber sollte die Brechzahl der hochbrechenden Reflektorschicht jedoch maximal so groß wie die Brechzahl der TCO-Schicht gewählt werden, da die TCO-Schicht die Breite der Winkelverteilung der reflektierten Strahlung innerhalb der Absorberschicht auf einen Maximalwert von 53 ° begrenzt und eine weitere Anhebung der Brechzahl der ersten Reflektorschicht über die Brechzahl der TCO-Schicht keine weitere Verbreiterung der Winkelverteilung bewirken würde.

In einer weiteren Ausführungsform wird die Rückelektrodenschicht durch eine hochdotierte Oberflächenschicht der Absorberschicht ausgebildet. In diesem Fall ergibt sich der Schichtaufbau Reflektor-Absorber, welcher dem Standardaufbau von einem kommerziell realisierten Solarzellentyp entspricht. In diesem Fall wirkt sich prinzipiell eine Brechzahl des dielektrischen Reflektors bis hoch zu der Brechzahl der Absorberschicht positiv auf die Breite der Streukeule in der Absorberschicht aus. In der Praxis ergeben sich jedoch aus verfügbaren Pigmenten und Trägerstoffen auch hier Begrenzungen für die Brechzahl der Reflektorschicht.

Erfindungsgemäß weist der pigmentierte dielektrische Reflektor senkrecht zu den Funktionsschichten einen Brechzahlverlauf mit zumindest zwei unterschiedlichen Brechzahlen n₁ und n₂ auf, mit einer Brechzahl n₁ in einem Abstand d₁ vom Absorber und einer Brechzahl n₂ in einem Abstand d₂ vom Absorber, wobei die Brechzahl n₁ nahe dem Absorber größer ist als die Brechzahl n₂ ferner dem Absorber. Der Brechzahlverlauf kann dabei einem Stufenprofil entsprechen und in mehreren Einzelschritten zur Absorberschicht hin zunehmen, es kann sich aber auch um einen kontinuierlichen Brechzahlverlauf handeln. In einer weniger bevorzugten Ausführungsform nimmt die Brechzahl des pigmentierten dielektrischen Reflektors zur Absorberschicht hin kontinuierlich zu. Ein kontinuierlicher Verlauf der Brechzahl über die Dicke des Reflektors kann zum Beispiel realisiert werden, in dem bei dem Abscheidungsprozess des Reflektors dessen Schichtzusammensetzung kontinuierlich geändert wird. Bevorzugt umfasst der pigmentierte dielektrische Reflektor jedoch mehrere Einzelschichten mit jeweils innerhalb einer Einzelschicht konstanten Zusammensetzung und konstanter Brechzahl.

In einer bevorzugten Ausführungsform umfasst der pigmentierte dielektrische Reflektor [5] eine erste der Absorberschicht [3] zugewandte, sowie eine zweite Reflektorschicht [6, 7], wobei die erste Reflektorschicht [6] einen ersten Trägerstoff mit einer Brechzahl n_{T, 1} sowie darin eingebettete Pigmente umfasst und die zweite Reflektorschicht [7] einen zweiten Trägerstoff mit einer Brechzahl n_{T, 2} sowie darin eingebettete Pigmente umfasst. Diese Ausführungsform ist fertigungstechnisch im allgemeinen mit dem geringsten Aufwand zu realisieren und daher bevorzugt.

Die Reflektorschichten werden durch Pigmente innerhalb eines Trägerstoffes gebildet. Die Pigmente umfassen bevorzugt mindestens ein Pigment aus der Gruppe Rutil, Anatas, BaSO₄ oder ZnS und weisen eine mittlere Partikelgröße im Bereich von 0,1 µm bis 5 µm auf. Die genannten Weißpigmente zeichnen sich durch hohe Brechzahlen sowie eine hohe spektrale Reflektion im sichtbaren Spektralbereich sowie im NIR (Nahes Infrarot) aus. Die beste Streuwirkung wird ferner erreicht, wenn die Partikel die angegebene Partikelgröße im Bereich der Wellenlänge der zu streuenden Strahlung aufweisen. Bei noch kleineren Partikel lässt die Streuwirkung deutlich nach. Deutlich größere Partikel weisen an ihrer Oberfläche eine starke Streuung auf, jedoch wird der Anteil der streuenden Oberflächen je Volumeneinheit bei größeren Partikeln reduziert. Besonderes bevorzugt weisen die Pigmente daher eine Partikelgröße im Bereich von 0,1 µm bis 1 µm auf.

Der Anteil der Pigmente in der ersten und zweiten Reflektorschicht beträgt bevorzugt 10 bis 90 Vol.-% und besonders bevorzugt 30 bis 60 Vol.-%. Bei diesen Pigmentanteilen wird im allgemeinen die höchste Streuwirkung erreicht, da der Anteil der streuenden Grenzflächen je Volumeneinheit dann besonders groß ist und damit das höchste Deckungsvermögen erreicht wird. Die Schichtdicken der Reflektorschichten können dementsprechend eine geringe Schichtdicke aufweisen.

In einer weiteren Ausführungsform weist die erste Reflektorschicht [6] eine Transluzenz von 10 % bis 90 %, bevorzugt 25 % bis 75 % auf. In diesem bevorzugten mittleren Bereich einer Transluzenz von 25 % bis 75 % werden die erfindungsgemäßen Vorteile in höchstem Maße erreicht, da dann zum einen die erste Reflektorschicht eine relative geringe Schichtdicke aufweisen kann und eine geringe Gesamtschichtdicke des Reflektors erreicht werden kann und zum anderen die von einer weiteren Reflektorschicht zurückgestreute Strahlung mit entsprechend hoher Wahrscheinlichkeit innerhalb der ersten Reflektorschicht wieder in höhere Winkelbereich gestreut wird. Bei einer Transluzenz von weniger als 10 % oder mehr als 90 % ist das hingegen nur sehr eingeschränkt der Fall.

In einer bevorzugten Ausführungsform weist der Trägerstoff der ersten Reflektorschicht[6] einer Brechzahl n_{T, 1} von mindestens 1,6, bevorzugt mindestens 1,7 und besonders bevorzugt mindestens 1,8 auf.

In einer weiteren bevorzugten Ausführungsform weist der Trägerstoff der zweiten Reflektorschicht [7] eine Brechzahl n_{T, 2} von weniger als 1,6, bevorzugt weniger als 1,55 und besonders bevorzugt weniger als 1,5 auf. Die Brechzahlen der Reflektorschichten ergeben sich dabei insbesondere aus der Verfügbarkeit von geeigneten Trägerstoffen und Pigmenten mit den gewünschten physikalischen Eigenschaften, welche in Verbindung mit der erforderlichen Brechzahldifferenz zwischen den Reflektorschichten einen optimalen Reflektoraufbau ermöglichen. Der Trägerstoff in der zweiten niedrigbrechenden Reflektorschicht kann prinzipiell einen sehr kleine Brechzahl im Bereich 1,0 bis 1,5 aufweisen, ist aber durch verfügbare geeignete Materialien auf einen Bereich von etwa 1,3 bis etwa 1,6 beschränkt. Je geringer die Brechzahl ist, desto höher ist bei gleicher Pigmentbrechzahl die Deckkraft und desto geringer ist bei gegebener Schichtdicke die Transluzenz.

Die Brechzahl n_{T,1} ist bevorzugt mindestens 0,1, bevorzugt mindestens 0,2 und besonders bevorzugt mindestens 0,3 größer als die Brechzahl n_{T,2}, wobei die erfindungsgemäßen Vorteile mit steigendem Brechzahlunterschied immer deutlicher hervortreten. Da der Trägerstoff jedoch auch eine möglichst hohe Transmission aufweisen sollte, sowie weitere Eigenschaften aufweisen muss, sind unter kommerziell verfügbaren Trägerstoffen keine mit einer Brechzahl von > 1,6 zu finden. Die Trägerstoffe müssen sich neben der Anforderung an die Brechzahl auch durch gute Witterungsbeständigkeit, gute mechanische Beständigkeit und Temperatur-Wechselbeständigkeit auszeichnen.

Die entsprechenden Brechzahlen der Trägerstoffe sowie der Brechzahlunterschied zwischen erster und zweiter Reflektorschicht können durch verschiedene Materialsysteme realisiert werden. Die erste Reflektorschicht muss erfindungsgemäß eine höhere Brechzahl aufweisen, was durch Trägerstoffe handelsüblicher Farben nicht ohne weiteres realisiert werden kann.

Der Trägerstoff der ersten Reflektorschicht umfasst bevorzugt ein organisches und/oder hybridpolymeres und/oder Polysiloxan-basiertes Basismaterial und besonders bevorzugt ein organisch/anorganisches Hybridpolymer als Basismaterial und kann ferner hochbrechende Nanopartikel umfassen.

Der Trägerstoff der ersten Reflektorschicht wird bevorzugt nach dem Sol-Gel-Verfahren aus hydrolysier- und polykondensierbaren Silizium-bzw. Silizium-organischen-Verbindungen und gegebenenfalls hydrolysier- und polykondensierbaren Titan-, Zirkon-, Aluminium-, Zink-, Magnesium-, Calcium-, Cer-, Samarium-, Gadolinium-, Lanthan-, Bor-, Yttrium- und/oder Zinn- Verbindungen hergestellt. Beispeilsweise können diese kondensierbaren Bestandteile aus der Gruppe der Acrylsilane, Epoxysilane, Acrylalkoxysilane, Acrylepoxysilane, Epoxyalkoxysilane, Allysilane, Vinylsilane, Fluoralkylsilane, Aminosilane, Alkoxysilane, Metallalkoholate, Metalloxidacrylate, Metalloxidmethacrylate, Metalloxidacetylacetonate sein. Im speziellen sind dies beispielsweise folgende Stoffe: Methacryloxypropylsilan, Glycidylpropylsilan, Zirkonsecundärbutylatacrylat, Titanethylatacrylat, Titanpropylatacrylat, Zirkonsecundärbuthylatmethacrylat, Titanethylatmethacrylat, Titanpropylatmethacrylat, Tetraethoxysilan, Tetramethoxysilan, Methyltriethoxysilan, Methyltrimethoxysilan, Ethyltrimethoxysilan, Propyltrimethoxysilan, Mercaptopropyltrimethoxysilan, Aminopropylsilan, Vinyltriethoxysilan, Allyltriethoxysilan, Phenyltriethoxysilan, Triethoxysilylpropylbernsteinsäureanhydrid, Fluoroctylsilan. Das Kondensat ist **dadurch gekennzeichnet, dass** der anorganische Kondensationsgrad des Hydrolysat größer gleich 50 %, bevorzugt größer 70 % beträgt.

Bevorzugt ist die Silizium- bzw. Silizium-organische Verbindung photochemisch oder thermisch polymerisierbar.

Der Trägerstoff der ersten Reflektorschicht [6] kann neben dem genannten Basismaterial hochbrechende Nanopartikel mit einer Brechzahl von mindestens 2,0 zu einem Anteil von mindestens 10 Vol.-%, bevorzugt mindestens 20 Vol.-% mit einer mittleren Größe von 2 nm bis 50 nm, bevorzugt 4 nm bis 30 nm umfassen, wodurch die Brechzahl angehoben wird. Nanopartikel bewirken im Gegensatz zu den größeren Pigmenten aufgrund ihrer geringen Größe unterhalb der Wellenlänge der solaren Strahlung nur eine sehr geringe Streuung der Strahlung, sondern bewirken im wesentlichen eine Brechzahlerhöhung des Trägerstoffes. Aufgrund dieser anderen physikalischen Wirkung können die Nanopartikel in der vorliegenden Erfindung im Gegensatz zu den Pigmenten als Bestandteil des Trägerstoffes verstanden werden und werden entsprechend so dargestellt. Die genannten Nanopartikel werden insbesondere aufgrund ihrer hohen Brechzahl, aber auch aufgrund guter Verfügbarkeit bevorzugt eingesetzt. Dadurch kann eine hoher Brechzahl von 1,6 bis 2,1, bevorzugt 1,65 bis 1,85 realisiert werden.

Die hochbrechenden Nanopartikel umfassen bevorzugt ein oder mehrere Oxide aus der Gruppe ZrO₂, Y₂O₃ stabilisiertes ZrO₂, CaO stabilisiertes ZrO₂, MgO stabilisiertes ZrO₂, CeO₂ stabilisiertes ZrO₂, MgO, CaO, Pyrochlore des Zr/Ti/Hf/Nb wie SmTi₂O₇, LaZr₂O₇, CeTi₂O₇, CeO₂, La₂O₃, LaHf₂O₇, Gd dotiertes CeO₂, HfO₂, Al dotiertes ZnO, In dotiertes ZnO, Sb dotiertes ZnO, SnO₂, ZnO und besonders bevorzugt TiO₂ in der Form von
Anatase und/oder Rutil. Diese Nanopartikel sind in einer bevorzugten erfindungsgemäßen Ausführungsform reaktiv in das ausgehärtete Basismaterial der Reflektorschicht eingebettet. Das bedeutet, dass eine chemische Reaktion der bevorzugt oxidischen Oberfläche und deren Hydroxylgruppen mit den organisch bzw. den anorganisch vernetzbaren Funktionalitäten stattgefunden hat. Bevorzugt werden die Nanopartikel chemisch mit Silanolgruppen oder anderen hydroxylgruppen von Metalloxiden und oder deren Metallorganischen beziehungsweise Hybridpolymeren Verbindungen verbunden. In dieser bevorzugten Ausführungsform entstehen deshalb zwischen den Nanopartikeln und der umgebenden Schicht keine Poren, welche sonst zu einer Erniedrigung der Brechzahl des Schichtmaterials führen würden. In einer besonderen erfindungsgemäßen Ausführungsform können Bestandteile der Matrix Polysiloxane sein. Bespielsweise können dies Methyl, Phenylpolysiloxane sein, welche beispielsweise Hydroxyl, Glycidyl, Polyether terminiert sind.

Desweiteren kann die Reflektorschicht organische Additve wie beispielsweise Dipentaerythritolpentaacrylat, Hexandioldiarylat, Trimethylolpropantriacrylat, Bernsteinsäureanhydrid als Härter umfassen. Für die Herstellung von erfindungsgemäßen Schichten kann dem Sol-Gel-Trägerstoff außerdem ein Eindicker, wie beispielsweise polydisperse Kieselsäure, Cellulose und oder Xanthan zugesetzt werden.

In einer besonderen erfindungsgemäßen Ausführungsform werden dem Sol-Gel-Trägerstoff Zusatzstoffe wie Verlaufshilfsmittel, welche beispielsweise aus der Stoffklasse der Polyethermodifizierten Dimethylsiloxane stammen können zugegeben. Die Schichten können beispielsweise durch Sprühen, Rollcoaten, Fluten, Rakeln, Tampondruck, Siebdruck etc. aufgebracht werden. Ein besonders bevorzugtes Auftragverfahren stellt der Siebdruck dar.

Das Materialsystem der zweiten niedrigbrechenden Reflektorschicht [7] kann gemäß Stand der Technik ausgebildet werden. Dabei kann die zweite Reflektorschicht [7] zum Beispiel eine Farbschicht umfassen, die als Trägerstoff vorzugsweise Acrylate, Methacrylate, Epoxyde, Polyvinylalkohol, Polystyrol, Wasserglas, Polyurethan, Polysiloxan oder sonstige übliche Trägerstoffe umfasst. Neben geringer Brechzahllage zeichnen sich diese Trägerstoffe durch gute Verfügbarkeit, gute Dispergierbarkeit der Pigmente sowie eine Vielzahl von möglichen Auftragsverfahren wie z.B. Streichen, Rollen, Drucken, Sprühen aus.

In einer weiteren bevorzugten Ausführungsform umfassen eine oder beide der Reflektorschichten [6, 7] eine Folie, so dass diese Reflektorschicht gleichzeitig eine rückseitige Verkapselung der Solarzelle bewirkt. Vorzugsweise wird eine EVA-Folie (Ethylenevinylacetate), eine PVA-Folie (Polyvinylalkohol) oder ein TPT-Mehrschichtlaminat-Folie eingesetzt, in welche die Pigmente eingebracht sind. Ein TPT-Mehrschicht-Laminat umfasst in der Regel eine Polyesterfolie, auf welche beidseitig eine PVF-Folie (Polyvinylfluorid) aufgeklebt ist. Diese Folien zeichnen sich insbesondere durch hohe Klimabeständigkeit und geringe Wasserdurchlässigkeit aus. Der mehrschichtige Reflektor kann bei dieser Ausführungsform besonders effizient realisiert werden. Sind beide Reflektorschichten als Folien ausgebildet, können diese selbstverständlich auch in Form eines Mehrschichtlaminates vorliegen, welches auf die Rückelektrode bzw. die Absorberschicht auflaminiert wird.

Die erste Reflektorschicht [6] weist bevorzugt eine Schichtdicke von 5 µm bis 60 µm, bevorzugt 10 µm bis 40 µm auf, und die zweiten Reflektorschicht [7] eine Schichtdicke von 10 µm bis 1000 µm, bevorzugt 20 µm bis 400 µm. Mit den vergleichsweise geringen Schichtdicken der ersten Reflektorschicht [6] kann insbesondere die Transluzenz der ersten Reflektorschicht sichergestellt werden. Die Schichtdicke der zweiten Reflektorschicht [7] hängt stark davon ab, ob eine weiße Farbe hoher Deckkraft eingesetzt wird, oder eine Folie, welche gleichzeitig die Rückseitenverkapselung oder einen Teil der Rückseitenverkapselung darstellt. Während bei weißen Farben mit Schichtdicken von 100 µm eine ausreichende Opazität des Reflektors erreicht werden kann, sind im Falle der Folienausführung Schichtdicken der zweiten Reflektorschicht bis 1000 µm möglich.

Die Erfindung bezieht sich auf verschiedene Bauformen und Arten von Solarzellen. Sie umfasst Solarzellen, deren Absorberschicht amorphes Si (a-Si), mikrokristallines Si (µ-Si), rekristallisiertes amorphes, poly- oder monokristallines Silizium (c-Si), Cd, Te, In, Ga oder S umfasst. Bevorzugt umfasst die Erfindung Dünnschichtsolarzellen mit einer Schichtdicke des Absorbers von maximal 10 µm, wobei die Funktionsschichten auf einem Substrat [8] in einer Substrat- oder Superstratanordnung angeordnet sind. Die Erfindung umfasst aber auch Wafer-basierte Solarzellen mit einer Absorberstärke von mindestens 50µm.

Vorteilhafte Ausführungsformen der Erfindung sind im folgenden mit Hilfe der Figuren 1 und 2 dargestellt.
Figur 1: Schematische Darstellung einer Solarzelle mit dielektrischem Reflektor gemäß Stand der Technik
Figur 2: Schematische Darstellung einer Solarzelle mit zweischichtigem dielektrischem Reflektor am Beispiel einer Dünnschichtsolarzelle

Gemäß Figur 1 umfasst die Solarzelle [1] nach Stand der Technik eine Frontelektrodenschicht [2], eine photovoltaisch aktive Absorberschicht [3], eine Rückelektrodenschicht [4] sowie einen einschichtigen pigmentierten dielektrischen Reflektor [5]. Desweiteren sind in Figur 1 mögliche Strahlengänge für einfallende Strahlung dargestellt, woraus ersichtlich ist, dass das von dem dielektrischen Reflektor zurückgestreute Licht durch die Brechung an der Grenzfläche zum Absorber stark gebrochen wird und daher vom Absorber nicht effizient absorbiert werden kann. Gemäß Figur 2 umfasst die erfindungsgemäße Solarzelle [1] in einer bevorzugten Ausführungsform eine Frontelektrodenschicht [2], eine photovoltaisch aktive Absorberschicht [3], eine Rückelektrodenschicht [4] sowie einen pigmentierten dielektrischen Reflektor [5] mit einer ersten Reflektorschicht [6] sowie einer zweiten Reflektorschicht [7]. Die erste Reflektorschicht [6] umfasst Pigmente [10] in einem Trägerstoff mit hoher Brechzahl [12] und die zweite Reflektorschicht [7] umfasst Pigmente [10] in einem Trägerstoff mit geringer Brechzahl [11]. Desweiteren sind in Figur 2 mögliche Strahlengänge für einfallende Strahlung dargestellt, woraus ersichtlich ist, dass das von dem dielektrischen Reflektor zurückgestreute Licht weniger stark gebrochen wird und daher vom Absorber effizienter absorbiert werden kann. Desweiteren ist dargestellt, dass es aufgrund von Totalrefelektion zu einem Light-Trapping-Effekt kommen kann.

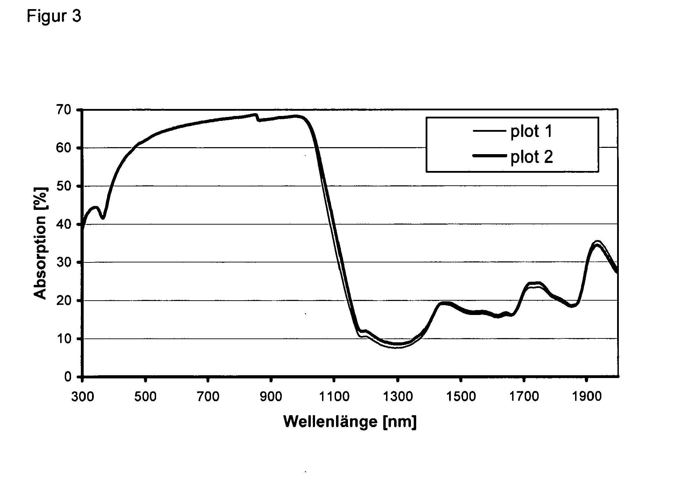

Für den Nachweis der erfindungsgemäßen Eigenschaften wurde eine Farbformulierung für eine dielektrische erste Reflektorschicht mit einer Brechzahl von n = 1,7 verwendet. Ein Si-Wafer wurde zum einen gemäß Stand der Technik mit einer einfachen, niedrigbrechenden dielektrischen Reflektorschicht sowie zum anderen mit der erfindunggemäßen doppelten Reflektorschicht versehen. Anschließend wurde die Absorption der beiden Schichtsysteme bestimmt, welche in Figur 3 dargestellt ist. Für die erfindungsgemäße Doppelreflektorschicht, welche in Figur 3 mit Plot 2 bezeichnet ist, wird gegenüber der einfachen Reflektorschicht, welche in der Figur mit Plot 1 bezeichnet ist, eine Verschiebung der Absorbanz-Kante in den langwelligen Spektralbereich beobachtet, welche eine Verbesserung des Light-Trappings belegt.

Nachstehend wird die Herstellung der hochbrechenden Reflektorschicht dargestellt.

In einem ersten Schritt wird der Basislack angesetzt, welcher die Vorstufe des Trägerstoffes der ersten Reflektorschicht darstellt. Mögliche Formulierungen für den Trägerstoff der hochbrechenden ersten Reflektorschicht sind für 3 Typen angegeben:
1) UV-härtbar, organisch und anorganisch vernetzend
2) thermisch härtbar, organisch und anorganisch vernetzend
3) thermisch härtbar, anorganisch vernetzend, siebdruckfähig

Ein erster Basislack, welcher UV-härtbar ist und organisch und anorganisch vernetzend ist, kann wie folgt erhalten werden: In einem Gefäß werden Methacryloxypropyltriethoxysilan (MPTES), Tetraethoxysilan (TEOS) und Methyltriethoxysilan (MTEOS) vorgelegt. In diesem Ausführungsbeispiel können beispielsweise etwa 0,75 mol MPTES, etwa 0,2 mol TEOS und etwa 0,005 mol MTEOS verwendet werden. Zu dieser Lösung wird anschließend langsam unter Kühlung und Rühren 23 g destilliertes Wasser versetzt mit 3,44 g Paratoluolsulfonsäure zugegeben. Nach 5 min rühren wird 900 g einer Dispersion aus 20 Gew.-% Anatas-Nanopartikel und einer Kristallitgröße von 10 bis 15 nm in n-Butanol hinzugegeben. Diese Lösung wird mit einer Lösung aus Zirkonpropylat und Methacrylsäure vereinigt. Beispielsweise können 0,75 mol MPTES, 0,02 mol TEOS und 0,05 mol MTEOS sowie eine Lösung aus 0,3 mol Zirkonpropylat und 0,3 mol Methacrylsäure verwendet werden. Nach Abschluss der Hydrolyse, welche einen Zeitraum von etwa 24 Stunden in Anspruch nehmen kann, wird das erhaltene Hybridpolymersol mit reaktiv eingebetteten fein dispergierten, nicht agglomerierten Nanopartikeln mit Methoxypropanol verdünnt. Der Lackformulierung wird ein Fotoinitiator zugesetzt. Als Fotoinitiator kann beispielsweise 1 Gew.-% des Fotoinitiators 1-Hydroxycyclohexylphenylketon, welcher unter dem Handelsnamen Irgacure 184^{®} erhältlich ist, bezogen auf das zähflüssige Hybridpolymer, zugesetzt werden.

Ein zweiter Basislack, welcher thermisch härtbar ist und organisch + anorganisch vernetzend ist, kann wie folgt erhalten werden:In einem Gefäß werden Glycidoxypropyltriethoxysilan (GPTES), TEOS und MTEOS vorgelegt. Beispielsweise werden etwa 0,6 mol GPTES, 0,2 mol TEOS und 0,2 mol MTEOS verwendet. Diese Lösung wird mit einer Lösung aus Aluminiumsecundärbutylat und Essigsäureethylester vereinigt, beispielsweise jeweils 0,1 mol. Zu dieser Lösung wird anschließend langsam unter Kühlung und Rühren eine saure Dispersion einer wässrigen nanopartikulären TiO₂-Dispersion, versetzt mit Methanol und Paratoluolsulfonsäure, gegeben. Beispielsweise können etwa 28 g einer TiO₂-Dispersion mit 18 Gew.-% Anatas und einer Kristallitgröße von 7 bis 12 nm, mit etwa 60 g Methanol und 3,44 g Paratoluolsulfonsäure versetzt, zugegeben werden. Nach 5 min rühren wird 1000 g einer Dispersion aus 20 Gew.-%,
Anatas-Nanopartikel und einer Kristallitgröße von 10 bis 15 nm in n-Butanol hinzugegeben. Nach Abschluss der Hydrolyse, welche einen Zeitraum von etwa 24 Stunden in Anspruch nehmen kann, wird das Lösungsmittel (z.B. Methanol/Ethanol) am Rotationsverdampfer entfernt. Das erhaltene Hybridpolymersol mit reaktiv eingebetteten fein dispergierten, nicht agglomerierten Nanopartikeln wird mit Methoxypropanol verdünnt. Es werden 0,05 mol Bernsteinsäureanhydrid hinzugegeben und der Lackformulierung wird ein Thermostarter zugesetzt. Als Thermostarter kann beispielsweise 2 Gew.-% an N-Methylimidazol zugesetzt werden.

Ein dritter Basislack, welcher thermisch härtbar, anorganisch vernetzend und siebdruckfähig ist, kann wie folgt erhalten werden: In einem Gefäß werden TEOS und MTEOS vorgelegt. In diesem Ausführungsbeispiel können beispielsweise etwa 0,2 mol TEOS und etwa 0,8 mol MTEOS verwendet werden. Zu dieser Lösung wird anschließend langsam unter Kühlung und Rühren eine saure Dispersion einer wässrigen nanopartikulären TiO₂-Dispersion, versetzt mit Methanol und Paratoluolsulfonsäure, gegeben. Beispielsweise können etwa 28 g einer TiO₂-Dispersion mit 18 Massenprozent, Anatas und einer Kristallitgröße von 7 bis 12 nm, mit etwa 60 g Methanol und 3,44 g Paratoluolsulfonsäure versetzt, zugegeben werden. Nach 5 min rühren wird 950 g einer Dispersion aus 20 Massenprozent, Anatase Nanopartikel und einer Kristallitgröße von 10 bis 15 nm in n-Butanol hinzugegeben. Nach Abschluss der Hydrolyse, welche einen Zeitraum von etwa 24 Stunden in Anspruch nehmen kann, wird das erhaltene Hybridpolymersol mit reaktiv eingebetteten fein dispergierten, nicht agglomerierten Nanopartikeln mit Diethylenglycolmonoethylether verdünnt und das leicht flüchtige Lösungsmittel bei100 mbar und 40 °C entfernt.

In einem zweiten Schritt können dem Basislack Pigmente hinzugesetzt werden. Je nach gewünschter Deckkraft werden den Basislackformulierungen üblicherweise 30 bis 60 Gew.-% an Weißpigmenten mit einer Größe von 100 nm bis 5 µm zugesetzt und mit einem Dispergiergerät dispergiert. Verwendete Partikel können insbesondere sein:
50 Gew.-% Rutil mit einer mittleren Partikelgröße von 350 nm bis 500 nm
60 Gew.-% Anatas mit einer mittleren Partikelgröße von 125 nm
45 Gew.-% ZnS mit einer mittleren Partikelgröße von 1000 nm

In einem dritten Schritt wird der Lack im Siebdruckverfahren aufgetragen und thermisch und oder photochemisch gehärtet.

### Bezugszeichenliste

- 1: Solarzelle
- 2: Frontelektrodenschicht
- 3: Absorberschicht
- 4: Rückelektrodenschicht
- 5: Dielektrischer Reflektor
- 6: erste Reflektorschicht
- 7: zweite Reflektorschicht
- 8: Substrat
- 10: Pigmente
- 11: Trägerstoff mit geringer Brechzahl
- 12: Trägerstoff mit hoher Brechzahl

## Patentansprüche

1. Solarzelle [1] mit einer Frontelektrodenschicht [2], einer photovoltaisch aktiven Absorberschicht [3], einer Rückelektrodenschicht [4] sowie einem pigmentierten dielektrischen Reflektor [5], **dadurch gekennzeichnet, dass** der pigmentierte dielektrische Reflektor [5] senkrecht zu den Funktionsschichten [3, 4, 5] einen Brechzahlverlauf mit zumindest zwei unterschiedlichen Brechzahlen n₁ und n₂ aufweist, mit einer Brechzahl n₁ in einem Abstand d₁ vom Absorber und einer Brechzahl n₂ in einem Abstand d₂ vom Absorber, wobei die Brechzahl n₁ nahe dem Absorber größer ist als die Brechzahl n₂ ferner dem Absorber.

2. Solarzelle nach Anspruch 1, wobei die Rückelektrodenschicht [4] durch eine TCO-Schicht mit einem Brechzahl n_{R} gebildet wird und wobei die maximale Brechzahl des dielektrischen Reflektors [5] höchstens der Brechzahl n_{R} der TCO-Schicht entspricht.

3. Solarzelle nach Anspruch 1, wobei die Rückelektrodenschicht [4] durch eine hochdotierte Oberflächenschicht als Oberflächenschicht der Absorberschicht [3] ausgebildet ist.

4. Solarzelle nach mindestens einem der vorhergehenden Ansprüche, wobei die Brechzahl des pigmentierten dielektrischen Reflektors zur Absorberschicht hin in mehreren Einzelschritten oder kontinuierlich zunimmt (graded index).

5. Solarzelle nach mindestens einem der vorhergehenden Ansprüche, wobei der pigmentierte dielektrische Reflektor [5] eine erste der Absorberschicht [3] zugewandte, sowie eine zweite Reflektorschicht [6, 7] umfasst, wobei die erste Reflektorschicht [6] einen ersten Trägerstoff mit einer Brechzahl n_{T,1} sowie darin eingebettete Pigmente [10] umfasst und die zweite Reflektorschicht [7] einen zweiten Trägerstoff mit einer Brechzahl n_{T,2} sowie darin eingebettete Pigmente umfasst.

6. Solarzelle nach Anspruch 5, wobei die Pigmente mindestens ein Pigment aus der Gruppe Rutil, Anatas, BaSO₄ oder ZnS umfassen und eine Partikelgröße im Bereich von 0,1 µm bis 5 µm, bevorzugt im Bereich von 0,1 µm bis 1 µm aufweisen.

7. Solarzelle nach mindestens einem der Ansprüche 5 und 6, wobei der Anteil der Pigmente in der ersten und zweiten Reflektorschicht 10 Vol.-% bis 90 Vol.-% und bevorzugt 30 Vol.-% bis 60 Vol.-% beträgt.

8. Solarzelle nach mindestens einem der Ansprüche 5 bis 7, wobei die erste Reflektorschicht [6] eine Transluzenz von 10 % bis 90 %, bevorzugt 25 % bis 75 % aufweist.

9. Solarzelle nach mindestens einem der Ansprüche 5 bis 8, wobei der Trägerstoff der ersten Reflektorschicht [6] einer Brechzahl n_{T,1} von mindestens 1,6, bevorzugt mindestens 1,7 und besonders bevorzugt mindestens 1,8 aufweist.

10. Solarzelle nach mindestens einem der Ansprüche 5 bis 9, wobei der Trägerstoff der zweiten Reflektorschicht [7] einer Brechzahl n_{T},₂ von weniger als 1,6, bevorzugt weniger als 1,55 und besonders bevorzugt weniger als 1,5 aufweist.

11. Solarzelle nach mindestens einem der Ansprüche 5 bis 10, wobei die Brechzahl n_{T,1} mindestens 0,1, bevorzugt mindestens 0,2 und besonders bevorzugt mindestens 0,3 größer als die Brechzahl n_{T,2} ist.

12. Solarzelle nach mindestens einem der Ansprüche 5 bis 11, wobei der Trägerstoff der ersten Reflektorschicht bevorzugt ein organisches und/oder hybridpolymeres und/oder Polysiloxan-basiertes Basismaterial und besonders bevorzugt ein organisch/anorganisches Hybridpolymer als Basismaterial umfasst.

13. Solarzelle nach mindestens einem der Ansprüche 5 bis 12, **dadurch gekennzeichnet, dass** der Trägerstoff der ersten Reflektorschicht [6] nach dem Sol-Gel-Verfahren aus hydrolysier- und polykondensierbaren Silizium-bzw. Silizium-organischen-Verbindungen und gegebenenfalls hydrolysierund polykondensierbaren Titan-, Zirkon-, Aluminium-, Zink-, Magnesium-, Calcium-, Cer-, Samarium-, Gadolinium-, Lanthan-, Bor-, Yttrium- und/oder Zinn- Verbindungen hergestellt ist.

14. Solarzelle nach Anspruche 13, **dadurch gekennzeichnet, dass** die Silizium-bzw. Silizium-organische Verbindung photochemisch oder thermisch polymerisierbar ist.

15. Solarzelle nach mindestens einem der Ansprüche 5 bis 14, wobei der Trägerstoff der ersten Reflektorschicht [6] hochbrechende Nanopartikel mit einer Brechzahl von mindestens 2,0 zu einem Anteil von mindestens 10 Vol.-%, bevorzugt mindestens 20 Vol.-% mit einer mittleren Größe von 2 nm bis 50 nm, bevorzugt 4 nm bis 30 nm umfasst, wodurch die Brechzahl angehoben wird.

16. Solarzelle nach Anspruch 15, wobei die hochbrechenden Nanopartikel ein oder mehrere Oxide aus der Gruppe ZrO₂, Y₂O₃ stabilisiertes ZrO₂, CaO stabilisiertes ZrO₂, MgO stabilisiertes ZrO₂, CeO₂ stabilisiertes ZrO₂, MgO, CaO, Pyrochlore des Zr/Ti/Hf/Nb wie SmTi₂O₇, LaZr₂O₇, CeTi₂O₇, CeO₂, La₂O₃, LaHf₂O₇, Gd dotiertes CeO₂, HfO₂, Al dotiertes ZnO, In dotiertes ZnO, Sb dotiertes ZnO, SnO₂, ZnO und besonders bevorzugt TiO₂ in der Form von Anatase und/oder Rutil umfassen.

17. Solarzelle nach mindestens einem der Ansprüche 5 bis 16, wobei die zweite Reflektorschicht [7] eine Farbschicht umfasst, die als Trägerstoff vorzugsweise Acrylate, Methacrylate, Epoxyde, Polyvinylalkohol, Polystyrol, Wasserglas, Polyurethan, Polysiloxan oder sonstige übliche Trägerstoffe umfasst.

18. Solarzelle nach mindestens einem der Ansprüche 5 bis 17, wobei eine oder beide der Reflektorschichten [6, 7] eine Folie umfasst, vorzugsweise eine EVA-Folie (Ethylene vinyl acetate), eine PVA-Folie (Polyvinylfluoride) oder ein TPT-Mehrschichtlaminat-Folie.

19. Solarzelle nach mindestens einem der Ansprüche 5 bis 18, wobei die erste Reflektorschicht [6] eine Schichtdicke von 5 µm bis 60 µm, bevorzugt 10 µm bis 40 µm aufweist, und die zweiten Reflektorschicht [7] eine Schichtdicke von 10 bis 1000 µm, bevorzugt 20 µm bis 400 µm aufweist.

20. Solarzelle nach mindestens einem der Ansprüche 1 bis 19, wobei die Absorberschicht amorphes Si(a-Si), mikrokristallines Si(µ-Si), rekristallisiertes amorphes, poly- oder monokristallines Silizium (c-Si), Cd, Te, In Ga, oder S umfasst.

21. Solarzelle nach mindestens einem der Ansprüche 1 bis 20, wobei es sich um eine Dünnschichtsolarzelle handelt und wobei die Funktionsschichten auf einem Substrat in einer Substrat- oder Superstratanordnung angeordnet sind.

22. Solarzelle nach mindestens einem der Ansprüche 1 bis 21, wobei es sich um eine Wafer-basierte Solarzelle mit einer Absorberstärke von mindestens 50 µm handelt.
